# EUROPEAN PATENT APPLICATION

(11) **EP 1 333 478 A1**
(43) Date of publication of application: **06.08.2003**
(21) Application number: 02100055.9
(22) Date of filing: 23.01.2002
(51) Int. Cl.: H01L 21/324

(54) **Method for manufacturing gallium nitride compound semiconductor element and gallium nitride compound semiconductor element**

(71) Applicant: Sakai, Shiro, Tokushima 770-8072 (JP); Nitride Semiconductors Co., Ltd., Naruto-shi, Tokushima 771-0360 (JP)
(72) Inventor: SAKAI, Shiro, 770-8072, Tokushima (JP)
(74) Representative: Weihs, Bruno

(57) **Abstract**

A method for obtaining a P type GaN compound semiconductor in a GaN compound semiconductor element. An N type GaN compound semiconductor layer is formed on a substrate. A GaN compound semiconductor layer to which a P type impurity is doped is formed on the N type GaN compound semiconductor layer. The GaN compound semiconductor layer to which the P type impurity is doped is irradiated with electromagnetic radiation of a predetermined wavelength to selectively agitate hydrogen bonds to dissociate H, and activate P type impurity as an acceptor.

## Description

### BACKGROUND OF THE INVENTION

### 1. Field of the Invention

The present invention relates to a method for manufacturing a gallium nitride (GaN) compound semiconductor element, and in particular to a method for manufacturing a PN junction element or the like.

### 2. Description of the Related Art

A wide variety of applications for GaN compound semiconductor LEDs emitting blue light (450 nm) or ultraviolet radiation are being considered.

As a GaN compound semiconductor, AlGaN and InGaN, and a laminated structure of these compounds and GaN are being considered. In order to use the compounds for a light emitting element, a PN junction must be provided. More specifically, an N type GaN compound semiconductor and a P type GaN compound semiconductor must be formed.

In order to form an N type GaN compound semiconductor, an N type impurity such as, for example, Si and Sn, can bedoped. However, it is generally difficult to form a P type GaN compound semiconductor. In other words, simple doping of a P type impurity such as, for example, Mg, to GaN, results in a semi-insulative material having a high resistance value. Therefore, such simple doping does not produce a P type GaN compound semiconductor. It is generally believed that this results because H atoms in NH₃, which is used for growing GaN, are absorbed into the crystal and bond to the doped Mg, thereby neutralizing the Mg.

Conventionally, methods are proposed, as described in, for example, Japanese Patent Laid-Open Publication No. Hei 10-178213, in which an annealing process is performed at a temperature of 700 °C or greater after an N type GaN compound semiconductor and a GaN compound semiconductor including a P type impurity are grown by vapor phase epitaxy on a substrate . By performing such an annealing process, H which is bonded in a form of Mg-H is thermally dissociated and removed, resulting in formation of Mg to which no H is bonded, and which can therefore effectively act as an acceptor.

Another proposed method is a method wherein an electron beam is irradiated after the P type impurity is doped.

However, in the method of annealing at a high temperature of 700 °C or greater in order to prepare a P type GaN compound semiconductor, the annealing process degrades the GaN itself, frequently resulting in degradation of the characteristics of the light emitting element.

Meanwhile, the method of irradiating an electron beam is not suited for use over large areas, and therefore is not an industrially practical approach.

### SUMMARY OF THE INVENTION

The present invention was conceived to solve the above described problems, and one object of the present invention is to provide a method for easily and reliably manufacturing a P type GaN compound semiconductor. Another object of the present invention is to provide a GaN compound semiconductor element which has superior characteristics.

In order to achieve one or more of these objects, according to one aspect of the present invention, there is provided a manufacturing method comprising the steps of (a) forming, on a substrate, an N type GaN compound semiconductor layer and a GaN compound semiconductor layer which includes a P type impurity, and (b) irradiating electromagnetic irradiation of a predetermined wavelength onto the GaN compound semiconductor layer which includes a P type impurity. By irradiating electromagnetic radiation of a predetermined wavelength onto the GaN compound semiconductor layer which includes a P type impurity, energy can be supplied to the bonded structure between the P type impurity and H. H can then be dissociated from the bonded structure by the supplied energy. As a result of this process, the P type impurity can function as an acceptor. Because H is dissociated by an electromagnetic wave, the GaN crystal to anywhere near the extent as when an annealing process is applied.

According to another aspect of the present invention, a wavelength which is selectively absorbed by the bonded structure of P type impurity and H atom is chosen as the predetermined wavelength. The bonded structure of P type impurity and H has a natural frequency and selectively absorbs an electromagnetic wave of a certain wavelength. In this manner, by irradiating electromagnetic radiation of such wavelength, energy can be supplied only to the bonded structure of P type impurity and H without significantly affecting the GaN bond, and H can be efficiently dissociated.

According to another aspect of the present invention, electromagnetic radiation of a predetermined wavelength is irradiated onto the GaN compound semiconductor layer which includes a P type impurity while heating the GaN compound semiconductor layer. In this manner, the bonded structure of P type impurity and H can be more efficiently agitated by synergistic effects between the electromagnetic energy and the thermal energy, and dissociation of H is facilitated.

According to another aspect of the present invention, there is provided a GaN compound semiconductor element comprising a substrate, an N type GaN compound semiconductor layer formed on the substrate, and a P type GaN compound substrate layer formed adjacent to the N type GaN compound semiconductor layer on the substrate. The P type GaN compound semiconductor layer is formed by irradiating electromagnetic radiation of a predetermined wavelength onto a GaN compound semiconductor layer to which a P type impurity is doped.

According to yet another aspect of the present invention, the wavelength of the electromagnetic radiation is set as a wavelength that is selectively absorbed by the bonded structure of the P type impurity and H.

### BRIEF DESCRIPTION OF THE DRAWINGS

Fig. 1 is a diagram showing relevant portions of a light emitting element according to the present invention.
Fig. 2 is a process flowchart of the present invention.
Fig. 3 is a structural diagram of the manufacturing apparatus according to the present invention.
Fig. 4 is a diagram for explaining irradiation of electromagnetic radiation in the present invention.
Fig. 5 is a diagram showing another configuration according to the present invention.

### DESCRIPTION OF PREFERRED EMBODIMENT

A preferred embodiment of the present invention will now be described referring to the figures and with a light emitting element as an example.

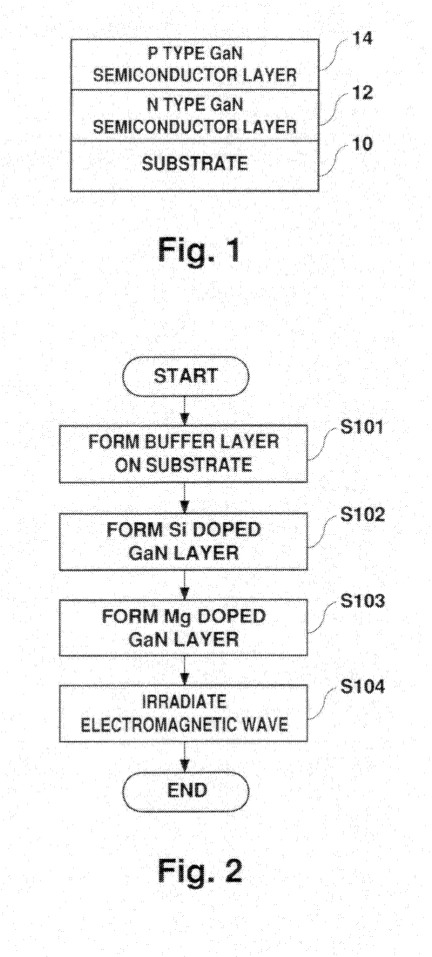

Fig. 1 shows relevant structures in a GaN compound semiconductor light emitting element (excluding electrodes etc.) which is manufactured by a method of manufacturing according to the preferred embodiment. An N type GaN compound semiconductor layer 12 is formed on a substrate 10 and a P type GaN compound semiconductor layer 14 is formed on the N type GaN compound semiconductor layer 12. Each of the layers can be formed using, for example, a MOCVD method. The N type GaN compound semiconductor layer 12 may comprise a single layer of GaN, AlGaN, or InGaN, or a laminated structure of these compounds (for example, GaN/AlGaN/InGaN including a superlattice structure (SLS etc.)), or by doping an N type impurity such as Si to these structures. When forming the N type compound semiconductor layer 12, a buffer layer may first be formed on the substrate 10 at a low temperature and the N type GaN compound semiconductor layer 12 may be formed on the buffer layer. The P type GaN compound semiconductor layer 14, on the other hand, is constructed by doping Mg or the like as a P type impurity to a single layer of GaN, AlGaN, or InGaN, or a laminated structure (including SLS) of these compounds. As described above, with simple doping of Mg, the layer would not be a P type. However, in the present embodiment, electromagnetic radiation of a predetermined wavelength is irradiated onto the layer after the P type impurity is doped, to thereby obtain a P type GaN compound semiconductor layer 14.

In the following, the manufacturing method will be described in detail using an example in which Si doped GaN is used as the N type GaN compound semiconductor layer 12 and Mg doped AlGaN is used as the P type GaN compound semiconductor layer 14.

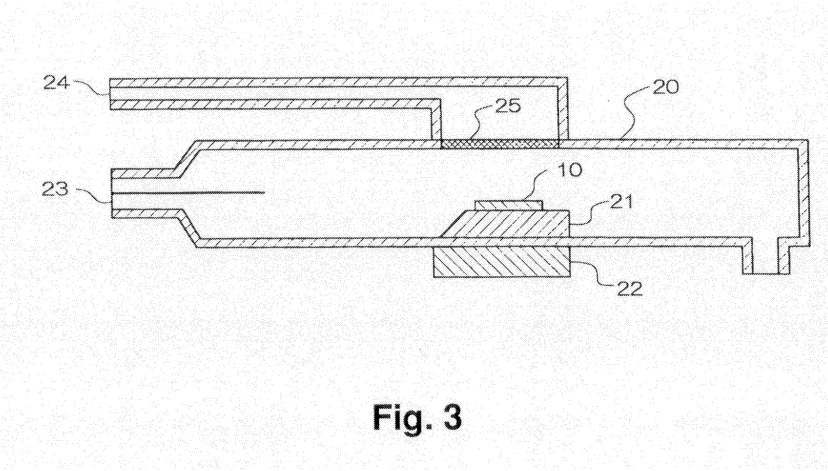

Fig. 2 shows a process flowchart of the manufacturing method according to the present embodiment and Fig. 3 shows an apparatus for manufacturing. A substrate 10 (sapphire or the like) is placed on a suspector 21 in a reaction tube 20. The substrate 10 is thermally treated by heating the substrate to 1150 °C in a H₂ atmosphere using a heater 22. After the thermal treatment, the substrate temperature is lowered to 450 °C, a mixed H₂ and N₂ gas is introduced as a carrier gas from a gas introduction section 24 via a fine porous member 25 having air permeability, and trimethyl gallium (TMG), NH₃, and H₂ are supplied from a gas introduction section 23 as a material gas, so that a buffer layer 11 is formed (step s101). Then, the substrate temperature is again raised to 1075 °C using the heater 22, and a gas including Si, for example, SiH₄, is supplied along with TMG, NH₃, and H₂ from the gas introduction section 23, similar to the above, to form a Si doped GaN layer (step S102). Then, a gas containing Mg, for example, Cp₂Mg, is introduced along with TMG, TMAl, NH₃, and H₂ from the gas introduction section 23, to form a Mg doped AlGaN layer (step S103).

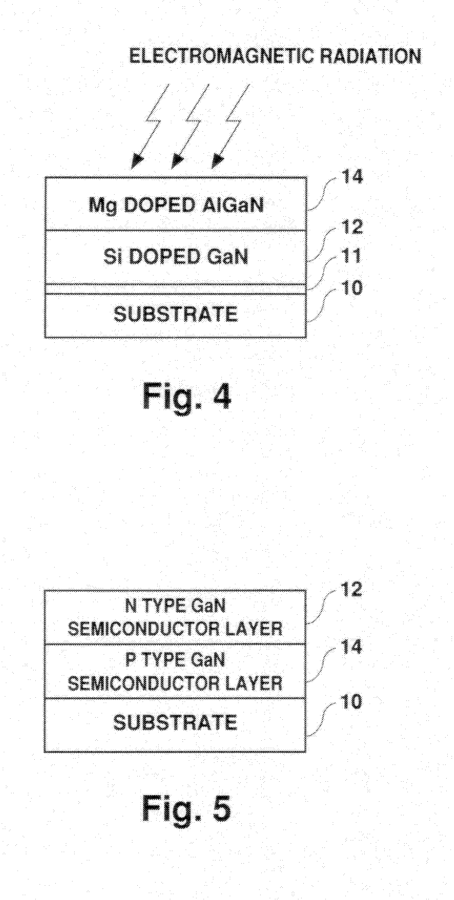

After forming GaN and AlGaN, the substrate 10 is taken out of the reaction tube 20 and placed in a light irradiating device. As shown in Fig. 4, an electromagnetic wave having a predetermined wavelength, for example, a wavelength of 4.5 µm, is irradiated onto the Mg doped AlGaN layer (step S104). As described above, Mg in the GaN compound semiconductor layer tends to bond with H, resulting in neutralization of Mg. The bond between Mg and H (Mg-H) has a natural frequency which is different from the natural frequency of Ga and N. The natural frequency of H within GaN is known to be 2168 cm⁻¹ and 2219 cm⁻¹ (Phys. Rev. B. Vol. 49, No. 20 14758, May 1994). The frequency of GaN bond, on the other hand, is known to be 900 cm⁻¹ and 1300 cm⁻¹ (Appl. Phys. Lett., 74, No. 19, 1999, 2788).

Therefore, when light having a wavelength of 4.5 µm is irradiated onto the Mg doped GaN compound semiconductor layer, the electromagnetic radiation is selectively absorbed by only the bond involving H, such that the electromagnetic radiation can selectively agitate such bonds. If the intensity of the irradiation light is sufficiently strong, the bonds can selectively be cut, and Mg to which no H is bonded can be obtained.

Mg to which no H is bonded can function as an acceptor, allowing the layer to function as the P type GaN compound semiconductor layer.

The necessary power for the electromagnetic wave depends on the absorption coefficient by hydrogen bond at that frequency. For example, when light having a wavelength of 4.5 µm is used, the power is preferably 0.01 mW/mm² or greater and, when electromagnetic radiation having a frequency of 2.45 GHz is used, the power is preferably 1 mW/cm² or greater.

Because GaN bond is not significantly affected by the irradiation of electromagnetic radiation, the GaN crystal is not degraded, even when high intensity electromagnetic radiation is employed.

In this manner, in the present embodiment, in order to dissociate H, the GaN compound semiconductor layer to which the P type impurity is doped is irradiated with electromagnetic radiation having a wavelength that is selectively absorbed by the bonded structure of a P type impurity and H . As a result, the P type impurity can function as an acceptor, and a P type GaN compound semiconductor layer can be obtained efficiently. In the embodiment, because H is not removed by annealing at a high temperature, there is no possibility that GaN crystal is degraded due to heat.

In the embodiment, it is also preferable to irradiate the electromagnetic wave while heating the entire element at a low temperature (500 °C or less) . In this manner, the H bondedstructure can be more efficiently agitated and H dissociation can be promoted. In the above described prior art (Japanese Patent Laid-Open Publication No. Hei 10-178213), the resistivity of the Mg doped GaN starts to decrease around 400 °C under annealing, and an almost constant resistivity can be obtained by annealing at a temperature of 700 °C or greater. In the embodiment, on the other hand, H dissociation is effected by the electromagnetic radiation, and the thermal energy is applied merely to assist this process . As a result, high temperature heating as employed in the prior art is not necessary, and the temperature can be preferably set to around 500 °C or around 400 °C.

Because a relatively low temperature is maintained, there is no reaction with the atmospheric gas during the electromagnetic irradiation. Because air can thus be used as the atmospheric gas, a very significant advantage for industrialization is realized.

While an illustrative example of the preferred embodiment of the present invention is described above, a number of variations are possible. For example, as shown in Fig. 5, it is also possible to first form a P type GaN compound semiconductor layer and then form an N type GaN compound semiconductor layer.

In the description of the preferred embodiment, a temperature of 500 °C is given as an example of a temperature at which a certain amount of thermal energy is supplied to the GaN compound semiconductor layer to which a P type impurity is doped while not thermally degrading the GaN crystal. Other temperatures such as, for example, 400 °C or less, can also be preferably chosen according to circumstances.

As a P type impurity, an element such as, for example, Mg, Zn, Cd, Be, and Ca can be used.

As the GaN compound semiconductor layer, GaN, AlGaN, or InGaN, a laminated structure of these compounds, or superlattice structure of these compounds can be used. The N type GaN compound semiconductor layer can be formed by doping an N type impurity such as, for example, Si and Sn, and in the case of a laminated structure, any one of the layers or all layers may be doped. The P type impurity can be doped in a similar manner.

An additional specific example of the preferred embodiment will now be described.

GaN having a thickness of 2 µm and to which Mg is doped was grown on a sapphire substrate by MOCVD. The resistivity of the resulting layer was so high that it could not be measured. 2.45 GHz electromagnetic radiation was irradiated at 60 mW/cm² for 5 minutes at room temperature and in an atmosphere of normal air. The resistance value was then measured, and it was found that the layer was a P type semiconductor having a resistance value of 10 Ω·cm. The same electromagnetic radiation was irradiated for 5 minutes onto a sample maintained at 400 °C. The resistivity was then measured, and it was found that the sample became a P type semiconductor with a resistance value of 1 Ωcm. With the known art, in order to obtain such resistivity with only the thermal process (annealing), thermal treatment at a temperature of 800 °C or greater in a nitrogen atmosphere or in a nitrogen atmosphere with 1% oxygen added is required. Also, while in the latter case, rough portions are typically observed on the GaN surface, the surface conditions of the sample produced using electromagnetic irradiation was employed were identical to those before irradiation.

As described, according to the present invention, a P type GaN compound semiconductor can be easily and reliably produced, and a light emitting element having superior characteristics can be obtained.

## Claims

1. A method for manufacturing a GaN compound semiconductor element, comprising the steps of:
(a) forming, on a substrate, an N type GaN compound semiconductor layer and a GaN compound semiconductor layer which includes a P type impurity; and
(b) irradiating electromagnetic radiation of a predetermined wavelength onto said GaN compound semiconductor layer which includes a P type impurity.

2. A method according to claim 1, wherein said electromagnetic radiation of a predetermined wavelength is electromagnetic radiation having a wavelength that is selectively absorbed by the bonded structure of said P type impurity and H.

3. A method according to claim 1, wherein said step (b) is performed while heating the substrate.

4. A method according to claim 1, wherein said step (a) includes the steps of:
(a1) forming a buffer layer on said substrate;
(a2) forming an N type GaN compound semiconductor layer on said buffer layer; and
(a3) forming said GaN compound semiconductor layer which includes a P type impurity on said N type GaN compound semiconductor layer.

5. A method according to claim 1, wherein said step (a) includes the steps of:
(a1) forming a buffer layer on said substrate;
(a2) forming said GaN compound semiconductor layer which includes a P type impurity on said buffer layer; and
(a3) forming said N type GaN compound semiconductor layer on said GaN compound semiconductor layer which includes a P type impurity.

6. A method according to claim 1, wherein said P type impurity is at least one of Mg, Zn, Cd, Be, and Ca.

7. A method according to claim 1, wherein light having a wavelength of 4.5 µm is irradiated with an intensity of 0.01 mW/mm² or greater at said step (b).

8. A method according to claim 1, wherein electromagnetic radiation having a frequency of 2.45 GHz is irradiated at an intensity of 1 mW/cm² or greater at said step (b).

9. A method according to claim 1, wherein said N type GaN compound semiconductor layer is formed by doping an N type impurity to a GaN compound semiconductor.

10. A GaN compound semiconductor element comprising:
a substrate;
an N type GaN compound semiconductor layer formed on said substrate;
a P type GaN compound semiconductor layer formed on said substrate and adjacent to said N type GaN compound semiconductor layer; wherein
said P type GaN compound semiconductor layer is formed by irradiating electromagnetic radiation of a predetermined wavelength onto a GaN compound semiconductor layer to which a P type impurity is doped.

11. An element according to claim 10, wherein said electromagnetic radiation of a predetermined wavelength is electromagnetic radiation having a wavelength that is selectively absorbed by the bonded structure of said P type impurity and H.

12. An element according to claim 11, wherein said electromagnetic radiation of a predetermined wavelength is light having a wavelength of 4.5 µm.

13. An element according to claim 11, wherein said electromagnetic radiation of a predetermined wavelength is electromagnetic radiation having a frequency of 2.45 GHz.

14. An element according to claim 10, wherein said Ptype GaN compound semiconductor layer is formed by irradiating said electromagnetic radiation of a predetermined wavelength while heating the GaN compound semiconductor layer to which the P type impurity is doped.
